# EUROPEAN PATENT SPECIFICATION

(11) **EP 1 834 760 B1**
(45) Date of publication and mention of the grant of the patent: **15.01.2014**
(21) Application number: 06111121.7
(22) Date of filing: 14.03.2006
(51) Int. Cl.: B32B 17/10, E06B 3/66, H01L 33/00, H01L 25/075, F21V 33/00, H01L 33/62, F21K 99/00

(54) **Glass product**
Produkt aus Glas
Produit en verre

(43) Date of publication of application: 19.09.2007
(73) Proprietor: AGC Glass Europe, 1170 Bruxelles (Watermael-Boitsfort) (BE)
(72) Inventor: Lefevre, Hugues, 6040 Jumet (BE)
(74) Representative: Bayot, Daisy

(56) References cited:
- EP-A- 1 437 215
- GB-A- 2 362 022
- PATENT ABSTRACTS OF JAPAN vol. 011, no. 033 (E-476), 30 January 1987 (1987-01-30) & JP 61 199683 A (KYOCERA CORP), 4 September 1986 (1986-09-04)
- PATENT ABSTRACTS OF JAPAN vol. 012, no. 080 (E-590), 12 March 1988 (1988-03-12) & JP 62 217677 A (KYOCERA CORP), 25 September 1987 (1987-09-25)

## Description

This invention relates to a panel incorporating a plurality of light emitting diodes (LEDs).

According to a first aspect, the present invention provides a panel as defined in Claim 1.

The dependent claims define features of preferred or alternative embodiments of the invention.

Other aspects of the invention are defined in other independent claims.

The panel may be a glazing panel and/or a lighting panel.

The invention is particularly applicable for use with LEDs having a plurality of light emitting dies contained within the same packaging, particularly RGB LEDs which have individual red, green and blue emitting dies adapted to be controlled individually provided within the same packing.

A relatively thin or narrow connection portion of the electrical pathway may facilitate connection with connection points of the LED packaging for the individual dies contained within. The spacing between connection points on the LED packaging may be of the order of 1 to 2 mm. A narrow connection portion may particularly facilitate connection between the electrical conduction coating and the interior or central connection points of a multi-die LED.

A relatively wide transfer portion of the electrical pathway may help to minimise electrical losses in the electrical pathways.

The electrically conducting pathways may be provided by an electrically conducting coating layer provided directly on one of the surfaces of the glass substrate. This may be a sputtered coating stack which may have a physical thickness in the range of 5 nm to 300 nm, for example a coating stack comprising ITO or silver. Alternatively, it may be a pyrolytic coating, particularly one deposited by chemical vapour deposition, which may have a thickness in the range of 100 nm to 5000 nm, for example a coating comprising tin oxide doped with fluorine or antimony. The sheet resistance of the conducting coating layer may be within the range of 1 to 6 ohms/square or within the range of 2 to 20 ohms/square.

Interruptions are provided in the conductive coating layer so as to define one or more electrical pathways; such interruptions may be provided by masking during deposition of the coating layer or by ablation, for example laser ablation, chemical etching, abrasion or cutting. Provision of the electrically conducting pathways directly on one of the surfaces of one of the glass substrate, particularly in the form of a coating layer, may facilitate cutting to size and/or handling and/or assembly.

Alternatively, the electrically conductive pathways may be provided by an electrically conductive coating layer provided on a substrate, for example a PET film, associated with the glass substrate, for example, laminated or adhered to the glass substrate. In this case, the coating layer may be a sputtered coating layer as referred to above.

The electrically conducting coating is preferably present over substantially the entire surface area of the substrate, for example over at least 90 % or 95 % of the surface area of the substrate. This may provide a substantially constant or homogeneous visual appearance over the panel.

The invention may facilitate a comprise or optimisation between one or more of the following factors:
- enabling a relatively thin electrical coating to be used;
- enabling connections between the coating and connection points in close proximity, for example connection points spaced less than 10 mm or less than 5 mm apart;
- avoiding unacceptably high electrical losses in the coating; electrical losses in the coating reduce the electrical efficiency of the glazing panel. In addition, in cases where these losses cause heat generation in the electrical coating , this may lead to an increased occurrence of failure of the electrical circuitry and/or be problematic for safety reasons.
- enabling a coating of substantially constant thickness and/or substantially constant visual appearance to be used.

The substrate(s) may be a glass sheet; a flat soda lime glass, noteably float glass, may be used for one and preferably both of the glass sheets. One or both of the glass sheets may be clear glass, extra clear glass or body tinted glass.

Particularly when intended for use in window applications, the glazing panel may be substantially transparent. In this case, it may have a light transmission (CIE Illuminant C) of greater than or equal to 40%, 50%, 60% or 70% and/or a level of haze of less than or equally to 5%, 3% or 2%.

Particularly when intended for decoration and/or lighting purposes, it may be unnecessary and/or undesired for the panel to be substantially transparent. In this case, it may have a light transmission (CIE Illuminant C) of less than or equal to 20%, 10%, or 5% and/or a level of haze of greater than or equally to 30%, 40% or 50%.

Use of a substantially transparent electrically conductive coating layer may be preferable when some or all of the LEDs are arranged to provide illuminate that will pass through the electrically conducting pathway.

The first and second glass sheets may be laminated together to form a laminated assembly by a plastics interlayer which comprises one or more sheets of PVB or a resin, for example EVA. The plastics interlayer may be substantially transparent; it may be neutral or clear in colour or it may be body tinted.

Preferably, the majority and more preferably substantially the entire surface area of the panel is provided with LEDs, that is to say that the LEDs form an array of spaced LEDs with the array covering greater than 50%, 60%, 70%, 80% or 90% of the surface area of the panel.

The glazing panel may incorporate at least 50, 100 or 200 LEDs.

The substrate(s), particularly when in the form of glass sheets preferably have a thickness within the range of 2.5 mm to 10 mm.

The glazing panel may have a mechanical resistance as defined in European Standard EN12600 (often referred to as the pendulum test) of 3B3, preferably 2B2 and more preferably 1B1.

The panel may be supplied with a relatively high voltage, that is to say a voltage within the range 55 to 400 volts, perhaps 210 to 250 volts or 290 to 300 volts. This may help to reduce electrical power losses in the coating.

Non-limiting embodiments of the invention are described with reference to the accompanying drawings of which
Fig 1 is a plan view of a panel ;
Fig 2 is an expanded cross section;
Fig 3 is a schematic view of one form of electrical pathways interconnecting adjacent LEDs;
Fig 4 is a schematic view similar to Fig 3 with an alternative form of LEDs;
Fig 5 is a schematic view of another form of electrical pathways interconnecting adjacent LEDs.

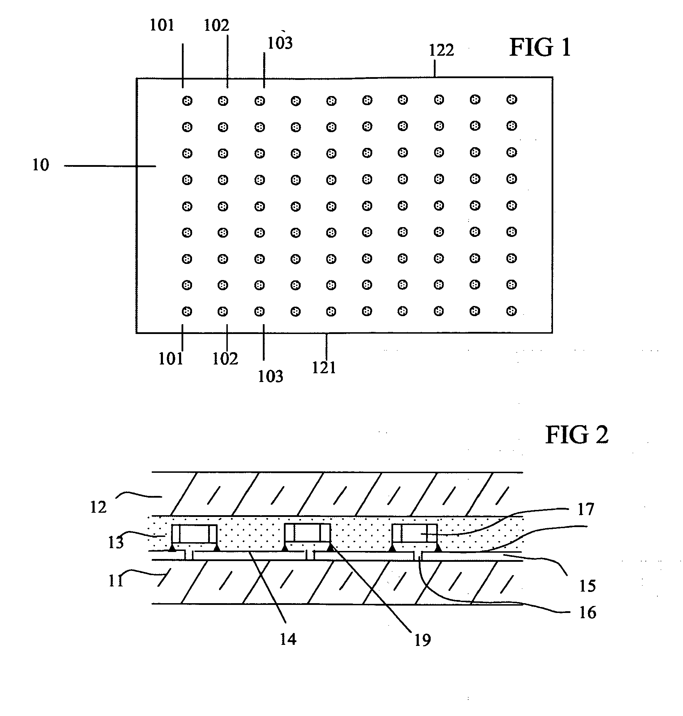

A glazing panel 10 comprises first 11 and second 12 flat, clear, 3mm thick soda lime float glass sheets laminated together by means of a 0.76 mm thick sheet of PVB 13. The inner surface 14 of the first glass sheet 11 is provided with a substantially colour neutral CVD coating stack 15 comprising an SiOxCy undercoat and an overlying Sn02:F coating. The coating has a resistance of about 15 ohms per square. Interruptions 16 in the coating stack 15 formed by laser ablations about 70 microns wide define electrically conducting pathways between LEDs 17 which are soldered or attached with an electrically conductive adhesive 19 either side of the laser ablations 16. Each LED is in direct contact with the coating 15 of the first glass sheet 11, the spacing shown in FIG 2 being schematic and not representative of the actual positioning. Additional laser ablations 18 divide the array of LEDs 17 in to individual lines of LEDs 101, 102, 103, etc which are connected in series. The lines of LEDs are connected to bus bars (not shown) positioned at opposite edges 121, 122 of the glazing panel.

In this embodiment, the LEDs are adapted to provide illumination through the second glass sheet 12, i.e. without passage through or hindrance by the conductive pathways provided by the coating layer 15.

The LEDs are arranged in a regular grid at 5cm intervals such that the array of diodes covers substantially the entire area of glazing panel. Each LED has a surface area of about 4mm².

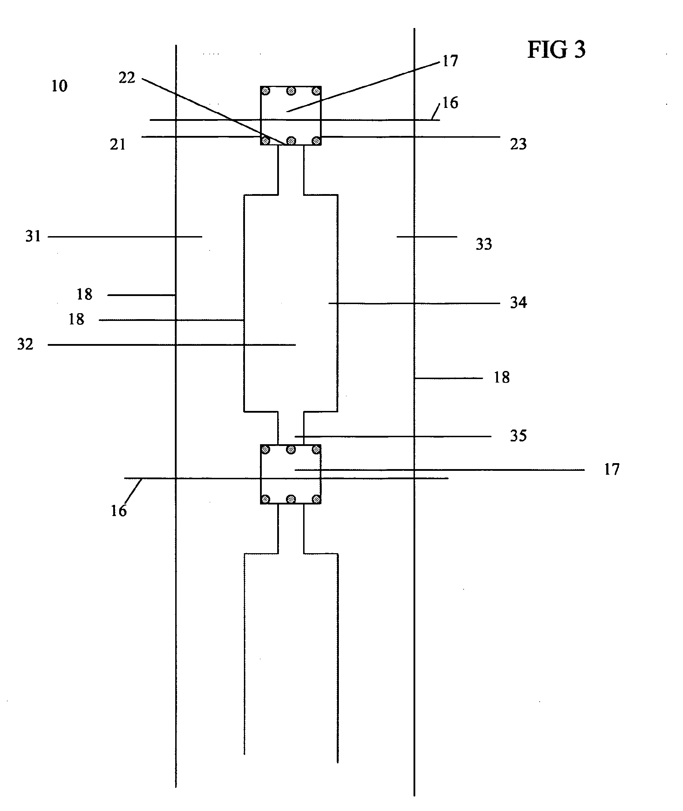

In the embodiment of Fig 3, each LED 17 is a RGB LED having three individual light emitting dies within its packaging. Each die has an associated connection or lead 21,22 23 arranged at the exterior of the packaging which is electrically connected to the its associated electrical pathway 31,32 33.

The connection portion 35 of electrical pathway 32 has a width of the order of 1 to 2 mm and is in the form of a narrowing of the transfer portion 34 of the electrical pathway. Transfer portion 34 may have a width of the order of 20 to 60 mm.

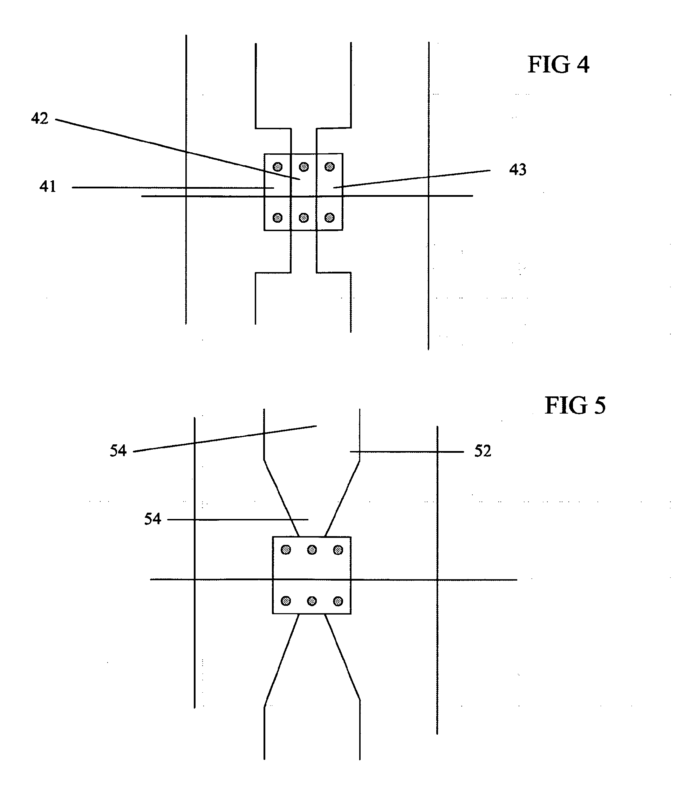

In the embodiment of Fig 4, three individual LEDs 41, 42 and 43 are arranged together in a cluster. These may be individual red, green and blue emitting LEDs.

In the embodiment of Fig 5, the narrowing of the electrical pathway 52 from the transfer portion 54 to form the connection portion 55 is achieved progressively rather than in a step. This may facilitate current flow within the electrical pathway; it may reduce the risk of creating hot spots; it may be more convenient to manufacture.

## Claims

1. A glazing panel comprising:
a glass substrate;
an electrically conductive coating layer;
a plurality of LEDs, with adjacent LEDs being electrically connected via electrical pathways defined within the electrically conductive coating layer,
the electrical pathways having connection portions adapted to be connected to a connection point or lead of a LED and a transfer portion adapted to provide electrical connection to an adjacent LED;
at least some of the electrical pathways comprising connection portions which are provided in the form of a narrowing of the width of their transfer portion.

2. A glazing panel in accordance with claim 1, in which at least some of the electrical pathways comprise a transfer portion which is at least 1.5 times wider than their connection portion, preferably at least 5, 10, 15 or 20 times wider.

3. glazing panel in accordance with claim 1 or claim 2, in which the narrowing of the electrical pathway from the transfer portion to form the connection portion is achieved progressively.

4. A glazing panel in accordance with any preceding claim, in which the adjacent LEDs contain a plurality of light emitting dies.

5. A glazing panel in accordance with any preceding claim, in which the adjacent LEDs are RGB LEDs, the red, green, and blue dies of the adjacent LEDs being interconnected via separate electrical pathways.

6. A glazing panel in accordance with any preceding claim, in which the electrically conductive coating layer is substantially transparent.

7. A glazing panel in accordance with any preceding claim, in which the electrically conductive coating is deposited directly on the surface of the glass substrate.

8. A glazing panel in accordance with any preceding claim, in which the glazing panel comprises a second substrate, spaced from the first substrate so that the LEDs are positioned between the two substrates.

9. A glazing panel in accordance with claim 8, in which the second substrate is a glass sheet, spaced from the first substrate with an intervening gas filled space..

10. A glazing panel in accordance with claim 8, in which the second substrate is a glass sheet and in which the two glass substrates are laminated together via plastics interlayer, preferably comprising a layer of pvb.

11. Use of electrical pathways having transfer portions and connection portions provided as a narrowing of the transfer portion to facilitate connection to LEDs and/or reduce electrical losses between LEDs in a glazing structure having adjacent LEDs connected via an electrically conductive coating.

## Patentansprüche

1. Verglasungsplatte, umfassend
ein Glassubstrat;
eine elektrisch leitfähige Beschichtungsschicht;
eine Mehrzahl von LEDs, wobei benachbarte LEDs durch elektrische Bahnen, die innerhalb der elektrisch leitfähigen Beschichtungsschicht definiert sind, elektrisch verbunden sind,
wobei die elektrischen Bahnen Verbindungsbereiche, angepasst zum Verbundenwerden mit einer Anschlusssstelle oder -leitung einer LED, und einen Transferbereich, angepasst zum Bereitstellen elektrischer Verbindung zu einer benachbarten LED, aufweisen;
wobei mindestens einige der elektrischen Bahnen Verbindungsbereiche, die in der Form einer Verjüngung der Breite ihres Transferbereichs bereitgestellt sind,
umfassen.

2. Verglasungsplatte nach Anspruch 1, in welcher zumindest einige der elektrischen Bahnen einen Transferbereich, welcher mindestens 1,5 mal breiter, vorzugsweise mindestens 5, 10, 15 oder 20 mal breiter als ihr Verbindungsbereich ist, umfassen.

3. Verglasungsplatte nach Anspruch 1 oder 2, in welcher die Verjüngung der elektrischen Bahn von dem Transferbereich zur Bildung des Verbindungsbereichs progressiv erreicht wird.

4. Verglasungsplatte nach einem vorhergehenden Anspruch, in welcher die benachbarten LEDs eine Mehrzahl lichtemittierender Würfel enthalten.

5. Verglasungsplatte nach einem vorhergehenden Anspruch, in welcher die benachbarten LEDs RGB LEDs sind, wobei die roten, grünen und blauen Würfel der benachbarten LEDs durch separate elektrische Bahnen miteinander verbunden sind.

6. Verglasungsplatte nach einem vorhergehenden Anspruch, in welcher die elektrisch leitfähige Beschichtungsschicht im Wesentlichen transparent ist.

7. Verglasungsplatte nach einem vorhergehenden Anspruch, in welcher die elektrisch leitfähige Beschichtung direkt auf der Oberfläche des Glassubstrates aufgebracht ist.

8. Verglasungsplatte nach einem vorhergehenden Anspruch, in welcher die Verglasungsplatte ein zweites Substrat, welches von dem ersten Substrat beabstandet ist, umfasst, so dass die LEDs zwischen den beiden Substraten posttioniert sind.

9. Verglasungsplatte nach Anspruch 8, in welcher das zweite Substrat eine Glasplatte, beabstandet von dem ersten Substrat mit einem dazwischenliegenden mit Gas gefüllten Bereich, ist.

10. Verglasungsplatte nach Anspruch 8, in welcher das zweite Substrat eine Glasplatte ist und in welcher die beiden Glassubstrate mittels einer Kunststoff-Zwischenschicht, die vorzugsweise eine Schicht aus PVB umfasst, aneinanderlaminiert sind.

11. Verwendung von elektrischen Bahnen mit Transferbereichen und Verbindungsbereichen, bereitgestellt als eine Verjüngung des Transferbereichs, zur Erleichterung der Verbindung mit LEDs und/oder zur Verringerung elektrischer Verluste zwischen LEDs in einer Verglasungsstruktur mit benachbarten LEDs, die über eine elektrisch leitfähige Beschichtung verbunden sind.

## Revendications

1. Un vitrage comprenant :
un substrat en verre ;
une couche de revêtement électriquement conductrice ;
une pluralité de LED, avec des LED adjacentes électriquement connectées par des circuits électriques définis à l'intérieur de la couche de revêtement électriquement conductrice ;
les circuits électriques ayant des portions de connexion adaptées pour être connectées à un point ou à un câble de connexion d'une LED et une portion de transfert adaptée pour fournir une connexion électrique à une LED adjacente ;
au moins certains des circuits électriques comprenant des portions de connexion sous la forme d'un rétrécissement de la largeur de leur portion de transfert.

2. Un vitrage selon la revendication 1, dans lequel au moins certains des circuits électriques comprennent une portion de transfert qui est au moins 1,5 fois plus large que leur portion de connexion, de préférence au moins 5, 10, 15 ou 20 fois plus large.

3. Un vitrage selon la revendication 1 ou la revendication 2, dans lequel le rétrécissement du circuit électrique partant de la portion de transfert pour former la portion de connexion est réalisé progressivement.

4. Un vitrage selon l'une quelconque des revendications précédentes, dans lequel les LED adjacentes contiennent une pluralité de puces électroluminescentes.

5. Un vitrage selon l'une quelconque des revendications précédentes, dans lequel les LED adjacentes sont des LED RVB, les puces rouges, vertes et bleues des LED adjacentes étant interconnectées via des chemins électriques séparés.

6. Un vitrage selon l'une quelconque des revendications précédentes, dans lequel la couche de revêtement électriquement conductrice est substantiellement transparente.

7. Un vitrage selon l'une quelconque des revendications précédentes, dans lequel la couche de revêtement électriquement conductrice est déposée directement sur la surface du substrat en verre.

8. Un vitrage selon l'une quelconque des revendications précédentes, dans lequel le vitrage comprend un second substrat, espacé du premier substrat de sorte que les LED soient positionnées entre les deux substrats.

9. Un vitrage selon la revendication 8, dans lequel le second substrat est une feuille de verre, espacée du premier substrat au moyen d'un espace intermédiaire rempli de gaz.

10. Un vitrage selon la revendication 8, dans lequel le second substrat est une feuille de verre et dans lequel les deux substrats en verre sont laminés ensemble au moyen d'une couche intermédiaire en plastique, comprenant de préférence une couche de PVB.

11. L'utilisation de circuits électriques ayant des portions de transfert et des portions de connexion sous forme d'un rétrécissement de la portion de transfert pour faciliter la connexion à des LED et/ou réduire les pertes électriques entre LED dans une structure de vitrage ayant des LED adjacentes connectées à l'aide d'un revêtement électriquement conducteur.
